# EUROPÄISCHE PATENTSCHRIFT

(11) **EP 0 841 842 B1**
(45) Veröffentlichungstag und Bekanntmachung des Hinweises auf die Patenterteilung: **01.08.2001**
(21) Anmeldenummer: 97119117.6
(22) Anmeldetag: 03.11.1997
(51) Int. Cl.: H05K 7/20

(54) **Steuergerät zur Ansteuerung des Elektromotors von Kraftfahrzeugen**
Control apparatus for driving the electrical motor of vehicles
Appareil de commande pour la commande du moteur électrique de véhicules

(30) Priorität: 06.11.1996 DE 19645635
(43) Veröffentlichungstag der Anmeldung: 13.05.1998
(73) Patentinhaber: TEMIC TELEFUNKEN microelectronic GmbH, 90411 Nürnberg (DE)
(72) Erfinder: Bäumel, Hermann, 92318 Neumarkt (DE); Flierl, Werner, 92237 Sulzbach-Rosenberg (DE); Kilian, Hermann, 91456 Diespeck (DE); Leicht, Günter, 96047 Bamberg (DE); Schuch, Bernhard, 91616 Neusitz (DE); Schüller, Ehrenfried, 90408 Nürnberg (DE)
(74) Vertreter: Maute, Hans-Jürgen, Dipl.-Ing.

(56) Entgegenhaltungen:
- EP-A- 0 734 199
- WO-A-94/17649
- DE-A- 2 710 432
- US-A- 4 019 098
- US-A- 4 758 926
- US-A- 5 504 378

## Beschreibung

Die Erfindung betrifft ein Steuergerät gemäß dem Oberbegriff des Patentanspruchs 1, wie es aus der EP 0 734 199 A2 bekannt ist.

Aufgrund ihrer geringen Emissionswerte wird anstelle der heute üblichen mit Verbrennungsmotoren betriebenen Kraftfahrzeugen zunehmend der Gebrauch von Kraftfahrzeugen mit Elektromotoren propagiert. Derartige Kraftfahrzeuge beziehen die Antriebsleistung für den Elektromotor in der Regel aus einer Traktionsbatterie. Der komplette Elektroantrieb einschließlich der Batterieladung und der Spannungswandlung vom Traktionsnetz ins Bordnetz des Kraftfahrzeugs wird durch eine zentrale Steuereinheit überwacht. Die hierfür vorgesehenen Steuergeräte bestehen in der Regel aus mehreren Funktionseinheiten (einer Leistungseinheit mit Umrichterfunktion, einer Spannungswandlereinheit zur DC-DC-Spannungswandlung der Batteriespannung auf die Versorgungsspannung des Kraftfahrzeugs, einer Bordladeeinheit zum Anschluß an das Stromversorgungsnetz, und einer Kontrolleinheit zur Überwachung der Spannungswandlereinheit und der Bordladeeinheit), aus einer Kühleinheit zur Wärmeabfuhr (bsp. der Verlustleistung der Leistungseinheit) und aus externen Anschlüssen (bsp. für Steckverbindungen zur Batterie und zum Elektromotor). Üblicherweise sind diese Funktionseinheiten im Steuergerät nicht räumlich voneinander separiert; dies hat zur Folge, daß die zu einer Funktionseinheit gehörenden Komponenten (Halbleiterbauelemente und/oder Baugruppen) an verschiedenen Stellen des Steuergeräts angeordnet sind.

Dieser standardmäßige Aufbau des Steuergeräts bedingt folgende Nachteile:
- neben der elektrischen Verbindung der Funktionseinheiten zueinander müssen auch die getrennt voneinander angeordneten Komponenten und Baugruppen einer Funktionseinheit (meist mittels Verbindungsleitungen bzw. Kabeln) elektrisch verbunden werden,
- es ist ein großer Aufwand für Verbindungsleitungen (Kabel) und Verbindungsstecker erforderlich, die Probleme hinsichtlich Zuverlässigkeit, Alterung usw. verursachen,
- die einzelnen Funktionseinheiten sind nur schlecht für sich allein auf ihre Funktionsweise hin prüfbar, eine vollständige Funktionsprüfung der Funktionseinheiten ist erst beim kompletten Steuergerät möglich,
- die Kühlung der Komponenten (Halbleiterbauelemente, Baugruppen) der Funktionseinheiten und damit des Steuergeräts ist oftmals nicht ausreichend bzw. muß großflächig dimensioniert werden, Leistungs-Halbleiterbauelemente werden oftmals getrennt von den anderen Halbleiterbauelementen separat an Kühlmöglichkeiten montiert,
- aufgrund der gegenseitigen Beeinflussung der einzelnen Funktionseinheiten und der zahlreichen Verbindungsleitungen zwischen den Funktionseinheiten treten EMV-Probleme auf,
- der Flächenbedarf bzw. Volumenbedarf und daher das Einbauvolumen des Steuergeräts ist groß,
- die Herstellung des Steuergeräts ist mit relativ hohen Kosten verbunden,
- die im Kfz-Bereich gestellten Anforderungen (bsp. hinsichtlich der Schwingungsbelastung) werden oftmals nicht erfüllt.

Bei der gattungsgemäßen EP 0 734 199 A2 mit einem nicht beschriebenen internen Aufbau der Funktionseinheiten, wird die Kontaktierung der Funktionseinheiten über Anschlußkabel und Anschlußstecker realisiert.

In der US 5,504,378 ist ein Schaltmodul für Elektromotoren von Kraftfahrzeugen beschrieben, bei dem zwei jeweils eine Schalteinheit aufnehmende Kühlkörper in einem Gehäuse angeordnet sind und über geeignete Mittel miteinander verbunden werden.

Der Erfindung liegt die Aufgabe zugrunde, ein Steuergerät zur Ansteuerung des Elektromotors von Kraftfahrzeugen anzugeben, das insbesondere einen einfachen Aufbau und gute Systemeigenschaften hinsichtlich Kosten, Zuverlässigkeit, Funktionsprüfung, Fertigungsvereinfachung und Umweltfreundlichkeit.

Diese Aufgabe wird erfindungsgemäß durch die Merkmale im Kennzeichen des Patentanspruchs 1 gelöst.

Vorteilhafte Weiterbildungen des Steuergeräts ergeben sich aus den weiteren Patentansprüchen.

Beim vorgestellten Steuergerät mit einem modularen kompakten Aufbau sind die in einem Gehäusekörper integrierten Funktionseinheiten als separate Funktionsmodule (Leistungsmodul, Bordwandlermodul, Spannungswandlermodul und Kontrollmodul) ausgebildet und sowohl funktionell als auch räumlich voneinander separiert, d.h. die Bestandteile (Baugruppen bzw. Komponenten) der verschiedenen Funktionsmodule sind jeweils für sich separat zusammengefaßt. Die Halbleiterbauelemente bzw. Baugruppen eines Funktionsmoduls sind dabei auf einem Schaltungsträger (bsp. einer Leiterplatte) angeordnet, der auf einem separaten Trägerkörper aus einem Material mit hoher Wärmeleitfähigkeit (bsp. ein metallischer Trägerkörper aus Aluminium) aufgebracht ist; dieser separate Trägerkörper mindestens eines der Funktionsmodule ist auf einem Kühlmodul angeordnet und sorgt hierdurch für einen guten Wärmekontakt zwischen den Halbleiterbauelementen der Funktionsmodule und dem Kühlmodul. Durch geeignete Anordnung der Funktionsmodule im Gehäusekörper kann die Kontaktierung der Funktionsmodule untereinander zum überwiegenden Teil auf einfache Weise (bsp. mittels Druckfederkontakten) erfolgen. Insbesondere ist folgender Aufbau des Steuergeräts vorgesehen:
- das Kühlmodul ist mittig (in einer mittleren Ebene) im Gehäusekörper angeordnet, so daß die Funktionsmodule mit ihrem Trägerkörper auf beiden Oberflächenseiten des Kühlmoduls, d.h. sowohl auf dessen Oberseite als auch auf dessen Unterseite aufgebracht werden können (das Kühlmodul wird somit beidseitig genutzt); die Halbleiterbauelemente der Funktionsmodule sind somit über ihre Montagefläche (den Schaltungsträger) und den Trägerkörper direkt mit dem Kühlmodul verbunden (wodurch ein guter Wärmetransport gewährleistet ist)
- das auf einer Oberflächenseite des Kühlmoduls angeordnete Leistungsmodul besteht aus mehreren integrierten Untereinheiten, bsp. einer Leistungseinheit, einer Ansteuereinheit und einer Signalverarbeitungseinheit. Die Halbleiterbauelemente der Untereinheiten des Leistungsmoduls werden auf den jeweiligen Schaltungsträger aufgebracht (bsp. mittels Planartechnologie auflaminiert). Der Kühlkörper des Kühlmoduls ist auf der Unterseite als integraler Bestandteil des Leistungsmoduls ausgebildet, indem er den Trägerkörper für die Leistungseinheit des Leistungsmoduls bildet und nach dem Aufbringen des Schaltungsträgers der Leistungseinheit auf den Trägerkörper bzw. Kühlkörper in das Kühlmodul (als Einlegeteil) eingefügt wird
- die auf der anderen Oberflächenseite des Kühlmoduls (d.h. entgegengesetzt zum Leistungsmodul) benachbart zueinander angeordneten Funktionsmodule Bordlademodul und Spannungswandlermodul sind mit ihrem jeweiligen separaten (metallischen) Trägerkörper direkt auf der (metallischen) Oberfläche des Kühlmoduls aufgebracht
- das Kontrollmodul ist so zwischen den beiden Funktionsmodulen Bordlademodul und Spannungswandlermodul angeordnet (gegen diese beiden Funktionsmodule gedrückt), daß es eine direkte Kontaktierung mit diesen beiden Funktionsmodulen ermöglicht; der Trägerkörper des Kontrollmoduls bildet eine der Außenseiten des Gehäusekörpers, d. h. ist Bestandteil des Gehäusekörpers
- mittels Hochstromkontakten, die als direkte Steckkontakte oder als Klemm-/Druckkontakte ausgebildet sein können und die vom Leistungsmodul ausgehend durch den Gehäusekörper hindurchgeführt sind, läßt sich die externe Verbindung zum Elektromotor hin realisieren
- Sensorsignale (bsp. vom Elektromotor) können ebenfalls über direkte Steck- oder Klemm-/Druckkontakte durch den Gehäusekörper hindurch zum Kontrollmodul geführt werden.

Das mit geringen Kosten, geringem Materialverbrauch und flexibel herstellbare modulare Steuergerät besitzt eine hohe Zuverlässigkeit und gute Recyclingeigenschaften:
- die verschiedenen Funktionsmodule des Steuergeräts können vor dem Zusammenbau des Steuergeräts einzeln für sich geprüft werden, beim Zusammenbau des Steuergeräts mit geringem Aufwand montiert werden und beim Zusammenbau oder nach dem Zusammenbau des Steuergeräts einzeln mit geringem Aufwand demontiert bzw. ausgetauscht werden
- die Anordnung der Funktionsmodule auf beiden Oberflächenseiten des Kühlmoduls bedingt einerseits einen kompakten Aufbau und andererseits eine gute Kühlwirkung der Funktionsmodule bzw. deren Halbleiterbauelemente (das Kühlmodul wird beidseitig ausgenutzt)
- zur Verbindung der Funktionsmodule ist nur eine geringe Anzahl an Verbindungsleitungen bzw. Verbindungssteckern erforderlich
- durch die mittige Anordnung des Kühlmoduls ist einerseits eine große Kühlkapazität gegeben, so daß das Kühlmodul relativ kleinflächig dimensioniert werden kann, und andererseits eine gute Abschirmwirkung der Funktionsmodule gegenüber externen Störeinflüssen gewährleistet
- aufgrund der Abschirmwirkung durch die Kühleinheit, der Separierung der Funktionsmodule und der geringen Zahl an Verbindungsleitungen werden EMV-Probleme weitgehend vermieden.

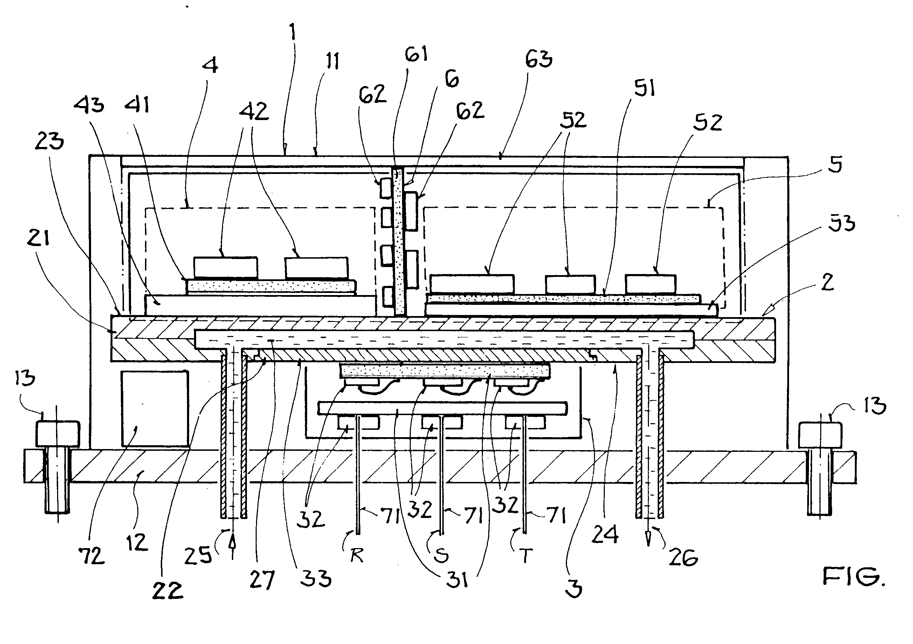

Das vorgestellte Steuergerät zur Ansteuerung des Elektromotors von Kraftfahrzeugen wird im folgenden anhand der Zeichnung beschrieben, wobei in der Figur ein Schnittbild des Steuergeräts dargestellt ist.

Gemäß der Figur weist das in einem Gehäusekörper 1 integrierte Steuergerät mehrere auf dem Kühlmodul 2 angeordnete, einzeln testbare und auswechselbare Funktionsmodule 3, 4, 5, 6 zur Realisierung unterschiedlicher Teilfunktionen des Steuergeräts auf: ein zentrales Kontrollmodul 6 zur Kontrolle bzw. Überwachung der gesamten Antriebselektronik des Elektromotors, ein Spannngswandlermodul 4 (DC-DC-Wandlermodul) zur Umwandlung der Batteriespannung der Traktionsbatterie (bsp. 300 V / 200 A) auf die Versorgungsspannung des Kraftfahrzeugs (Batteriespannung bsp. 12 V), ein Bordlademodul 5 zum Anschluß des Steuergeräts an das Stromversorgungsnetz (bsp. 230 V) und ein Leistungsmodul 3 als Umrichter zur Ansteuerung eines oder mehrerer Elektromotoren. Die Halbleiterbauelemente 32, 42, 52, 62 (Leistungs-Halbleiterbauelemente, Ansteuer-Halbleiterbauelemente und weitere Halbleiterbauelemente) von Leistungsmodul 3, Spannungswandlermodul 4, Bordlademodul 5 und Kontrollmodul 6 sind jeweils auf einem als Leistungssubstrat ausgebildeten Schaltungsträger 31, 41, 51, 61 aufgebracht (bsp. auf eine Leiterplatte in "Planartechnologie" oder einem DCB-Substrat: "direct copper bonding"), der auf einem separaten Trägerkörper 33, 43, 53, 63 aufgebracht ist; dieser separate Trägerkörper 33, 43, 53 der Funktionsmodule Leistungsmodul 3, Spannungswandlermodul 4 und Bordlademodul 5 ist direkt auf das Kühlmodul 2 aufgebracht.
Das von einem Kühlmedium 27 durchströmte Kühlmodul 2 mit integriertem Kühlkörper 22 als Einlegeteil ist bsp. als Aluminiumkühler oder Kupferkühler ausgebildet und mittig im Gehäusekörper 1 angeordnet. Auf der Unterseite 24 des Kühlmoduls 2 bzw. auf den das Unterteil des Kühlmoduls 2 darstellenden Kühlkörper 22 ist der Schaltungsträger 31 für die (Leistungs-)Halbleiterbauelemente 32 der Leistungseinheit des Leistungsmoduls 3 direkt aufgebracht, so daß der Trägerkörper 33 des Leistungsmoduls 3 durch das (bsp. aus Kupfer bestehende) Kühikörper-Einlegeteil 22 gebildet wird. Der Oberteil 21 des Kühlmoduls 2 wird durch eine Halbschale (beispielsweise aus Aluminium) gebildet, in die das Kühlmedium 27 (bsp. Wasser oder Glykol) durch die durch die Unterseite 12 des Gehäusekörpers 1 hindurchgeführte Einlaßöffnung 25 einströmt und durch die durch die Unterseite 12 des Gehäusekörpers 1 hindurchgeführte Auslaßöffnung 26 ausströmt; auf die metallische Oberfläche des Oberteils 21 des Kühlmoduls 2 (auf der Oberseite 23 des Kühlmoduls 2) werden die Trägerkörper 43, 53 von Spannungswandlermodul 4 und Bordlademodul 5 aufgebracht. Die Montagefläche der Halbleiterbauelemente 32, 42, 52 (d. h. der jeweilige Schaltungsträger 31, 41, 51) von Leistungsmodul 3, Spannungswandlermodul 4 und Bordlademodul 5 ist damit über ihren jeweiligen Trägerkörper 33 (22), 43, 53 in direktem Kontakt zum Kühlmedium 27 des Kühlmoduls 2, so daß die Halbleiterbauelemente 32, 42, 52 direkt gekühlt werden; hierdurch entsteht ein guter Wärmeübergang und eine gute Kühlung der Halbleiterbauelemente 32, 42, 52, insbesondere der Halbleiterbauelemente 32 des Leistungsmoduls 3 (bsp. von Leistungs-Transistoren der Leistungseinheit als Leistungsschalter). Die Oberfläche des Kühlkörpers 22 und damit dessen Kühlwirkung kann durch in Richtung des Kühlmediums 27 angeordnete Rippen vergrößert werden; die metallische Oberfläche auf der Oberseite 23 des Kühlmoduls 2 kann zur Vergrößerung der Montagefläche und hierdurch auch zur Vergrößerung der Kühlfläche gegenüber der Unterseite 24 des Kühlmoduls 2 verlängert werden. Der Trägerkörper 63 des Kontrollmoduls 6 ist in die Außenseite 11 des Gehäusekörpers 1 integriert bzw. bildet die Außenseite 11 des Gehäusekörpers 1; der Schaltungsträger 61 des Kontrollmoduls 6 ist senkrecht zwischen Spannungswandlermodul 4 und Bordlademodul 5 eingebracht und damit auf einfache Weise mit diesen (bsp. mittels Druckfederkontakten) kontaktierbar. Die auf der Unterseite 24 des (metallischen) Kühlmoduls 2 angeordneten Komponenten des Steuergeräts Leistungsmodul 3, Zwischenkreis-Kondensatoren 72 und die Phasenschienen R, S, T werden von den auf auf der Oberseite 23 des Kühlmoduls 2 angeordneten anderen Funktionsmodulen des Steuergeräts Spannungswandlermodul 4, Bordlademodul 5 und Kontrollmodul 6 gemäß EMV-Gesichtspunkten und entsprechend den vorhandenen Spannungsebenen getrennt (300 V für das Leistungsmodul 3, bsp. 12 V für die anderen Funktionsmodule).

Die durch den Gehäusekörper 1 hindurchgeführten, als Anschlußschienen 71 ausgebildeten Steckkontaktverbindungen sind direkt mit den entsprechenden Funktionsmodulen verbunden, bsp. mit dem Leistungsmodul 3 als Phasenschienen R, S, T für den Drehstrom des Elektromotors. Weiterhin sind an der Unterseite 12 (Grundplatte) des Gehäusekörpers 1 Befestigungsmittel 13 (bsp. Schrauben) vorgesehen, die zur Befestigung des Steuergeräts im Kraftfahrzeug (bsp. am Getriebeblock) dienen.

## Patentansprüche

1. Steuergerät zur Ansteuerung des Elektromotors von Kraftfahrzeugen, bei dem
- ein von einem Kühlmedium (27) durchströmtes, eine metallische Oberfläche aufweisendes Kühlmodul (2) mittig in einem Gehäusekörper (1) angeordnet ist,
- mehrere im Gehäusekörper (1) angeordnete, modular aufgebaute Funktionsmodule (3; 4; 5; 6) vorgesehen sind, wobei mindestens eines der Funktionsmodule (3; 4; 5; 6) entweder mit der Oberseite (23) oder der Unterseite (24) des Kühlmoduls (2) verbunden ist,
dadurch gekennzeichnet,
- daß die Halbleiterbauelemente (32; 42; 52; 62) der Funktionsmodule (3; 4; 5; 6) jeweils auf einem Schaltungsträger (31; 41; 51; 61) angeordnet sind, der auf einem separaten Trägerkörper (33; 43; 53; 63) aufgebracht ist, wobei mindestens einer der Trägerkörper (33; 43; 53) entweder mit der Oberseite (23) oder der Unterseite (24) des Kühlmoduls (2) verbunden ist,
- und daß senkrecht zur Gehäusewand aus dem Gehäusekörper (1) herausgeführte, die Halbleiterbauelemente (32) der Funktionsmodule (3; 4; 5; 6) kontaktierende Anschlußschienen (71) zum Anlegen von Steuersignalen zur Ansteuerung der Funktionsmodule (3; 4; 5; 6) und/oder zum Abgreifen von Ausgangssignalen (R, S, T) der Funktionsmodule (3; 4; 5; 6) und/oder zum Abgreifen von Sensorsignalen zur weiteren Signalverarbeitung vorgesehen sind.

2. Steuergerät nach Anspruch 1, dadurch gekennzeichnet, daß als Funktionsmodule (3; 4; 5; 6) vorgesehen sind:
- ein auf der Unterseite (24) des Kühlmoduls (2) angeordnetes Leistungsmodul (3), dessen Substratträger (31) auf einen als Einfügeteil in das Kühlmodul (2) integrierten, als Trägerkörper (33) dienenden Kühlkörper (22) aufgebracht ist,
- ein auf der Oberseite (23) des Kühlmoduls (2) angeordnetes Bordlademodul (5), dessen Trägerkörper (53) auf der metallischen Oberfläche des Kühlmoduls (2) angeordnet ist,
- ein auf der Oberseite (23) des Kühlmoduls (2) benachbart zum Bordlademodul (5) angeordnetes Spannungswandlermodul (4), dessen Trägerkörper (43) auf der metallischen Oberfläche des Kühlmoduls (2) angeordnet ist,
- ein Kontrollmodul (6), dessen Schaltungsträger (61) senkrecht zum Schaltungsträger (51) des Bordlademoduls (5) und zum Schaltungsträger (41) des Spannungswandlermoduls (4) orientiert ist und dessen Trägerkörper (63) einen Teil (11) des Gehäusekörpers (1) bildet.

3. Steuergerät nach Anspruch 2, dadurch gekennzeichnet, daß das Kontrollmodul (6) mit dem Bordlademodul (5) und dem Spannungswandlermodul (4) über Druckfederkontakte kontaktiert ist.

4. Steuergerät nach einem der Ansprüche 1 bis 3, dadurch gekennzeichnet, daß die Funktionsmodule (3; 4; 5) über metallische Trägerkörper (33; 43; 53) mit dem Kühlmodul (2) verbunden sind.

5. Steuergerät nach einem der Ansprüche 2 bis 4, dadurch gekennzeichnet, daß der Kühlkörper (22) des Kühlmoduls (2) eine strukturierte Oberfläche aufweist.

## Claims

1. A control device for controlling the electric motor of motor vehicles, wherein
- a cooling module (2), which has a metallic surface and has a cooling medium (27) flowing therethrough, is arranged centrally in a housing body (1),
- there are provided a plurality of modular functional modules (3; 4; 5; 6) arranged in the housing body (1), wherein at least one of the functional modules (3; 4; 5; 6) is connected either to the upper face (23) or the lower face (24) of the cooling module (2),
characterised
- in that the semiconductor elements (32; 42; 52; 62) of the functional modules (3; 4; 5; 6) are respectively arranged on a circuit support means (31; 41; 51; 61) which is mounted on a separate support member (33; 43; 53; 63), wherein at least one of the support members (33; 43; 53) is connected either to the upper face (23) or the lower face (34) of the cooling module (2),
- and in that terminal bars (71) are provided for the purposes of applying control signals for controlling the functional modules (3; 4; 5; 6) and/or for deriving output signals (R, S, T) from the functional modules (3; 4; 5; 6) and/or for deriving sensor signals for further signal processing, said terminal bars (71) being fed out of the housing body (1) perpendicularly relative to the housing wall and making contact with the semiconductor elements (32) of the functional modules (3; 4; 5; 6).

2. A control device in accordance with Claim 1, characterised in that the functional modules (3; 4; 5; 6) provided are:
- a power module (3) that is arranged on the lower face (24) of the cooling module (2) and the substrate support (31) whereof is mounted on a heat sink (22) which is integrated in the cooling module (2) in the form of an insert member and which serves as a support member (33),
- an on-board charging module (5) which is arranged on the upper face of the cooling module (2) and the support member (53) whereof is arranged on the metallic surface of the cooling module (2),
- a voltage converter module (4) which is arranged on the upper face (23) of the cooling module (2) adjacent the on-board charging module (5) and the support member (43) whereof is arranged on the metallic surface of the cooling module (2),
- a control module (6) the circuit support means (61) of which is oriented perpendicularly relative to the circuit support means (51) of the on-board charging module (5) and the circuit support means (41) of the voltage converter module (4), and the support member (63) of which forms a part (11) of the housing body (1).

3. A control device in accordance with Claim 2, characterised in that the control module (6) is contacted by the on-board charging module (5) and the voltage converter module (4) via compression spring contacts.

4. A control device in accordance with any of Claims 1 to 3, characterised in that the functional modules (3; 4; 5) are connected to the cooling module (2) via metallic support members (33; 43; 53).

5. A control device in accordance with any of Claims 2 to 4, characterised in that the heat sink (22) of the cooling module (2) comprises a structured surface.

## Revendications

1. Appareil de commande pour commander le moteur électrique de véhicules automobiles, dans lequel
- un module de refroidissement (2), qui est parcouru par un fluide de refroidissement (27) et possède une surface métallique, est disposé en position centrée dans un corps de boîtier (1),
- plusieurs modules fonctionnels (3; 4; 5; 6) agencés de façon modulaire et montés dans le corps de boîtier (1) sont prévus, au moins l'un des modules fonctionnels (3; 4; 5; 6) étant reliés soit à la face supérieure (23), soit à la face inférieure (24) du module de refroidissement (2),
caractérisé en ce que
- que les composants à semiconducteurs (32; 42; 52; 62) des modules fonctionnels (3; 4; 5; 6) sont disposés respectivement sur un support (31; 41; 51; 61) de circuits, qui est disposé sur un corps de support séparé (33; 43; 53; 63), au moins l'un des corps de support (33; 43; 53) étant relié à la face supérieure (23) ou à la face inférieure (24) du module de refroidissement (2), et
- que des rails de raccordement (71) qui ressortent perpendiculairement à la paroi du boîtier sur le corps de boîtier (1) et qui sont mis en contact avec les composants semiconducteurs (32) des modules fonctionnels (3; 4; 5; 6) sont prévus pour l'application de signaux de commande pour la commande des modules fonctionnels (3; 4; 5; 6) et/ou pour le prélèvement de signaux de sortie (R, S, T) des modules fonctionnels (3; 4; 5; 6) et/ou pour le prélèvement de signaux de capteurs pour le traitement ultérieur des signaux.

2. Appareil de commande selon la revendication 1,
caractérisé en ce qu'il est prévu comme modules fonctionnels (3; 4; 5; 6):
- un module de puissance (3) disposé sur la face inférieure (24) du module de refroidissement (2), dont le porte substrat (31) est disposé sur un corps de refroidissement. (22) intégré en tant qu'élément d'insertion dans le module de refroidissement (2) et utilisé en tant que corps de support (33),
- un module de chargement de bord (5), disposé sur la face supérieure (23) du module de refroidissement (2) et dont le corps de support (53) sur la surface métallique du module de refroidissement (2),
- un module de transformateur de tension (4), qui est disposé sur la face supérieure (23) du module de refroidissement (2) au voisinage du module (5) de chargement de bord et dont le corps de support (43) est disposé sur la surface métallique du module de refroidissement (2),
- un module de contrôle (6), dont le support (61) de circuits est orienté perpendiculairement au support (51) de circuits du module (5) de chargement de bord et est orienté vers le support (41) de circuits du module de transformateur de tension (4) et dont le corps de support (63) forme une partie (11) du corps de boîtier (1).

3. Appareil de commande selon la revendication 2, caractérisé en ce que le module de contrôle (6) est en contact avec le module (5) de chargement de bord et le module (4) de transformateur de tension par l'intermédiaire de contacts à ressorts de pression.

4. Appareil de commande selon l'une des revendications 1 à 3, caractérisé en ce que les modules fonctionnels (3; 4; 5) sont reliés au module de refroidissement (2) par l'intermédiaire de corps de support métalliques (33; 43; 53; 63).

5. Appareil de commande selon l'une des revendications 2 à 4, caractérisé en ce que le corps de refroidissement (22) du module de refroidissement (2) possède une surface structurée.
